# EUROPEAN PATENT APPLICATION

(11) **EP 2 270 976 A1**
(43) Date of publication of application: **05.01.2011**
(21) Application number: 10167927.2
(22) Date of filing: 30.06.2010
(51) Int. Cl.: H03F 1/52, H03F 3/24, H03G 3/30, H04W 52/52, H04W 52/34, H04W 24/00

(54) **Optimising operating temperature in a power amplifier**

(30) Priority: 30.06.2009 ES 200930383
(71) Applicant: Vodafone Group PLC, Newbury Berkshire RG14 2FN (GB); Vodafone España, S.A.U., 28108 Alcobendas (ES)
(72) Inventor: Arranz Arauzo, Miguel, E-28050, Madrid (ES); Gomez Coloma, Alberto, E-28050, Madrid (ES); Güemes Cabrejas, Inigo, E-28050, Madrid (ES)
(74) Representative: Keston, David Arthur

(57) **Abstract**

Method and system for optimising operating temperature in a power amplifier (3) of a base station (2) of a cellular telecommunications network. The system comprises:
- a power amplifier (3) of a BTS (2), the power amplifier configured for:
• measuring its operating temperature;
• if the operating temperature exceeds a temperature threshold *T_{TH}*, sending an alarm message to a controller unit (1);

- the controller unit (1), which can be included in the BTS (2) or in the corresponding BSC or RNC, configured for analyzing the alarm messages received and, when determined conditions are met, executing at least one action from a list of actions to reduce the dissipated power of the power amplifier (3).

## Description

### Field of the Invention

The present invention is comprised within the field of mobile telecommunications, and more specifically in a system and method for reducing the temperature of power amplifiers of base stations for cellular telecommunications networks.

### Background of the Invention

Power amplifiers (PA from now on) are active elements that amplify an electric signal. These transistors usually have two inputs:
- PA bias, the DC power supplied to the transistors.
- RF signal to be amplified.

The transistors use the DC power supplied in order to get a similar, but amplified, signal to the RF signal input.

The power amplifiers are based on transistors that usually have a temperature range where they can operate. Operating temperature depends mainly on two factors:
- Ambient temperature.
- Additional temperature caused by power dissipation. Electric elements usually dissipate power and this is also the case in PAs. This power dissipation depends on a lot of different parameters configured in the PA, such as:
   ○ Total output power.
   ○ Number of carriers.
   ○ Frequency separation between carriers.
   ○ Modulation used.
   ○ DC power supplied.

There are different mechanical techniques in order to prevent this dissipated power from increasing the operating temperature too much: Fans; liquid cooling, mechanical design in order to improve air dissipation; air conditioning; etc.

When the maximum temperature threshold is surpassed there are several techniques that are designed to reduce this operating temperature. However they are mainly based on hardware and implemented directly in the PA, and their main function is to reduce the total output power in the PA.

In the past, GSM equipment has been based on PAs that can handle just one carrier. Therefore when the PA exceeds maximum temperature, there was only one countermeasure: reduce the total output power.

However, more recently, equipment has been introduced that allows more than one GSM carrier to be present in one PA. This type of equipment also allows multi-bearer technology (2G, 3G, LTE, WiMAX) inside one PA, enabling further countermeasures that can help to reduce power dissipated in the PA, and therefore reduce the total temperature in the equipment.

In this single RAN (multi-bearer technology) equipment power and frequency resources are common and shared between the different technologies. Several countermeasures can be implemented in order to reduce the power dissipated by the PA.

There are presently several solutions for reducing the power consumption of the power amplifiers used at the base station (BTS), also known as Node B in UMTS, of a mobile network. These solutions are either based on more efficient power amplifiers or techniques based on more sophisticated hardware, which, while feasible and quite efficient for new implementations, are not particularly useful for existing, legacy networks.

Document WO9633555 discloses a temperature compensated automatic gain control, which reduces temperature in order to control the operating temperature, avoiding reaching maximum temperature.

Document EP0735690 discloses a method for controlling power of radio apparatuses. It is in fact hardware that controls the temperature so that output power do not exceed a maximum value.

It is therefore an object of the invention to obviate or at least mitigate the aforementioned problems.

It is well-known that abbreviations and acronyms are frequently used in the mobile telephony field. Below is a glossary of acronyms/terms used throughout the present specification:
- BSC: Base Station Controller
- BTS: Base Transceiver Station
- GSM: Global System for Mobile Communications
- MCPA: Multi-Carrier Power Amplifier
- PA: Power Amplifier
- RAN: Radio Access Network
- RNC: Radio Network Controller
- UMTS: Universal Mobile Telecommunications System

### Description of the Invention

When the power amplifiers (PAs) reach their maximum temperature, actions must be taken. Normally, the actions adopted are aimed to reduce the total output power in the PA. The present invention proposes a method to reduce the dissipated power without reducing the total output power.

The invention relates to a method for reducing operating temperature in power amplifiers of base stations of mobile networks according to claim 1 as set out below, and to an apparatus according to claim 10. Preferred embodiments of the apparatus and method are defined in the dependent claims.

In accordance with one aspect of the present invention there is provided a method for optimising operating temperature in a power amplifier of a base station (BTS) of a cellular telecommunications network, the method comprising:
- measuring the operating temperature in the power amplifier;
the method further comprising:
- sending an alarm message to a controller unit if the operating temperature exceeds a temperature threshold *T_{TH}*;
- analyzing the alarm messages received; and,
- when predetermined conditions are met, executing at least one action from a list of actions to reduce the dissipated power of the power amplifier.

The alarm message can include the temperature measured in the power amplifier. The predetermined conditions to execute the at least one action from a list of actions to reduce the dissipated power of the power amplifier can include calculating a weighted average of the temperatures measured in the last x alarm messages, being x configurable, and comparing said weighted average with the temperature threshold *T_{TH}*.

The list of actions can include:
- reduce output power for packet data connections;
- reduce total output power for voice calls;
- change users from high power dissipation modulations to modulations that are more power efficient.
- redo frequency allocation;
- reduce total output power;
- reallocate 2G users from filled up timeslots to empty timeslots.

The actions included in the list of actions can be prioritized.

The sending of the alarm message to the controller unit can be carried out via the BTS through the alarm link.

The parameter T_{TH} is preferably configurable through the controller unit.

The method can further comprise:
- if the operating temperature exceeds a temperature reduction threshold *TR_{TH}*, sending the power amplifier an alarm message to a controller unit indicating said circumstance and, in that case, executing the controller unit at least one action from the list of actions to reduce the dissipated power of the power amplifier.

In accordance with a further aspect of the present invention there is provided apparatus for reducing operating temperature in a power amplifier of a base station (BTS) of a cellular telecommunications network, the apparatus including: a temperature sensor for measuring the operating temperature of the power amplifier, a controller unit for executing actions in the power amplifier; and an alarm unit for sending an alarm message to the controller unit if the operating temperature exceeds a predetermined temperature threshold *T_{TH}*; the controller unit being operable to analyse the alarm messages received and, when determined conditions are met, executing at least one action from a list of actions to reduce the dissipated power of the power amplifier. The controller unit can be included in the BTS or in the BSC/RNC corresponding to the BTS. The alarm unit is provided with processing means such as a microprocessor or a microcontroller connected to the temperature sensor, in charge of periodically monitoring the temperature measured by the sensor to sending, when an alarm condition is detected, an alarm message to the controller unit. For that purpose the alarm unit can be provided with transmission means (e.g., a wireless communication module).

Power amplifiers have a working temperature range and performance will highly depend on the working temperature. This invention targets a more efficient power feed of the power amplifiers based on the expected power amplifier performance depending on the temperature.

There are known solutions that monitor and control the temperature in radios and PAs. However they are mainly directed at preventing equipment from reaching maximum temperature. The present invention, by contrast, is focused on optimizing several radio parameters, e.g. as MTBF, number of carriers, carrier separation, etc.

Another difference between the existing solutions and the present invention is that these solutions are mainly design algorithms and hardware that are implemented by the manufacturers of network hardware while the present invention allows the mobile operator to configure the behaviour of hardware. One goal of the present invention is thus to optimize the temperature based on different parameters.

### Brief Description of the Drawings

For a better understanding of the present invention, reference will now be made, by way of non-limiting example only, to the accompanying drawing in which:

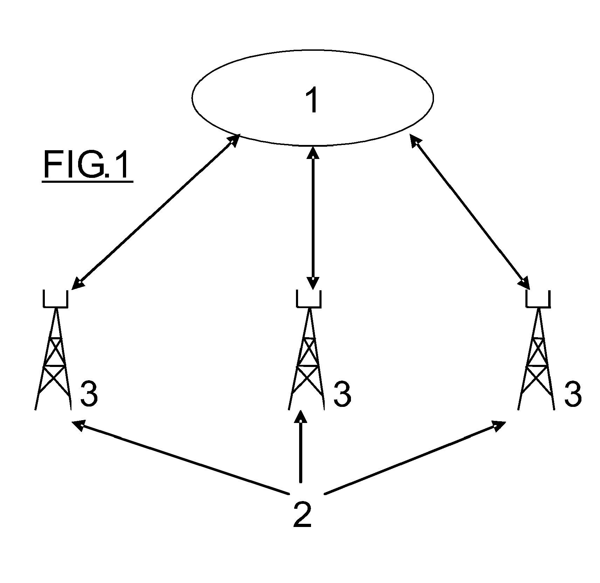

- Figure 1 shows a diagram of the different elements of the mobile network participating in the invention.

### Description of a Preferred Embodiment of the Invention

The present invention is based on having alternative algorithms that help to reduce the dissipated power without having to use the default implementation (decrease total output power) which can have a higher impact in network performance.

Power Amplifiers (PA) are elements implemented in the BTSs responsible for providing enough power to the signal that is going to be broadcasted in a mobile network. Conventional PAs 3, as shown in **Figure 1****,** already have a temperature sensor that detects the operating temperature in the PA 3. There is a maximum temperature and when that threshold is surpassed, PAs automatically reduce the output power until that temperature goes beyond that limit.

In the invention, a new limit is defined at a predetermined temperature value substantially below the conventional maximum temperature, in order to be able to launch some actions that are less aggressive before reaching that maximum temperature. The conventional limit will hereafter be referred to as T_{MAX} (the maximum permissible temperature in the PA, so that when T_{MAX} is reached the total output power in PA is reduced). The new limit will hereafter be referred to as T_{TH}. An alarm is be configured in the PA 3, so when T_{TH} is exceeded this alarm will be activated. The parameter *T_{TH}* is defined in the controller unit 1 (BSC/RNC) and distributed to the BTSs 2 and PAs 3 through the normal O&M (Operations & Maintenance) links.

Whenever there is an alarm, PA 3 sends a message to the controller unit 1 via the BTS 2 through the normal alarm link defined by each supplier. This message initially only includes the temperature measured. The rest of the message will be blank in order to leave space for future enhancements.

Controller unit 1 takes several of the temperature measurements reported in order to make a more reliable decision and avoid launching the algorithm when there is a sudden peak measurement that effectively should not have any effect. Therefore controller unit 1 is able to have a weighing process in order to get to this significant value (e.g. minimum 4 alarms required and a normal average will be done). Additionally in the controller unit 1 there can be an additional threshold, a temperature reduction threshold *TR_{TH}* in order to decide when to launch the temperature reduction algorithm. Whenever this threshold is surpassed, controller unit executes the algorithm in order to reduce temperature in the PA. This parameter *TR_{TH}* will typically be higher than *T_{TH}*. Logic approach is that there is a processing part in the controller that takes into consideration temperature values sent by the BTS. For example, a decision will only be made when at least a predetermined number of samples (say, x samples) have been received and an average of those x samples will be taken, the average being compared with *TR_{TH}* or with *T_{TH}*. In this way, decisions made based on peak sample values are avoided. This process can be quite complex and therefore it should be left open (e.g. average could be linear or weighted, such that the most recent sample is weighted higher than previous samples: for every sample: last sample multiplied by 1, previous one multiplied by 0.8, etc.).

Controller unit 1 has a parameter defining the priority list of the actions to be taken. Different actions can be made an each of them can be also prioritized between different technologies (2G/3G/LTE):
- Reduce output power for packet data connections. Controller unit 1 will recalculate the output power that is required in order to go below *TR_{TH}*.
- Change users from high power dissipation modulations (8-PSK, 16QAN, 32 QAM, 64 QAM,..) to modulations that are more power efficient (e.g. GMSK)
- Reallocate 2G users from filled up timeslots to empty timeslots.
- Redo frequency allocation. In MCPA (Multi-Carrier Power Amplifier) frequency separation impacts power efficiency and the total power that is dissipated. If carriers have smaller frequency separation, then less power will be dissipated.
- Reduce total output power for voice calls. Different priorities depending on the technology can be used (2G,3G, LTE,..)
- Reduce total output power. This is the default hardware implementation right now when temperature is surpassed. Main difference is that right now it is controlled by controller unit 1 and therefore reducing impact in QoS.

## Claims

1. Method for optimising operating temperature in a power amplifier (3) of a base station (2) of a cellular telecommunications network, the method comprising:
- measuring the operating temperature in the power amplifier (3);
**characterized in that** the method further comprises:
- sending an alarm message to a controller unit (1) if the operating temperature exceeds a temperature threshold *T_{TH}*,;
- analyzing the alarm messages received; and,
- when predetermined conditions are met, executing at least one action from a list of actions to reduce the dissipated power of the power amplifier (3).

2. Method according to claim 1, wherein the alarm message includes the temperature measured in the power amplifier (3).

3. Method according to the previous claim, wherein the predetermined conditions to execute the at least one action from a list of actions to reduce the dissipated power of the power amplifier (3) include calculating a weighed average of the temperatures measured in the last N alarm messages, N being a predetermined number, and comparing said weighed average with the temperature threshold *T_{TH}*.

4. Method according to any of previous claims, wherein the list of actions includes:
- reduce output power for packet data connections;
- reduce total output power for voice calls;
- change users from high power dissipation modulations to modulations that are more power efficient.

5. Method according to the previous claim, wherein the list of actions further includes at least one of the following:
- redo frequency allocation;
- reduce total output power;
- reallocate 2G users from filled up timeslots to empty timeslots.

6. Method according to any of previous claims, wherein the actions included in the list of actions are prioritized.

7. Method according to any of previous claims, wherein the sending of the alarm message to the controller unit (1) is carried out via the BTS (2) through the alarm link.

8. Method according to any of previous claims, wherein the parameter T_{TH} is configurable through the controller unit (1).

9. Method according to any of previous claims, further comprising:
- if the operating temperature exceeds a temperature reduction threshold *TR_{TH}*, sending the power amplifier (3) an alarm message to a controller unit (1) indicating said circumstance and, in that case, executing the controller unit (1) at least one action from the list of actions to reduce the dissipated power of the power amplifier (3).

10. System for optimising operating temperature in a power amplifier (3) of a base station (2) of a cellular telecommunications network, **characterized in that** it comprises:
- an apparatus including
a temperature sensor for measuring the operating temperature of the power amplifier (3),
an alarm unit for sending an alarm message to a controller unit (1) if the operating temperature exceeds a predetermined temperature threshold *T_{TH}*;
- a controller unit (1) operable to analyse the alarm messages received and, when predetermined conditions are met, executing at least one action from a list of actions to reduce the dissipated power of the power amplifier (3).

11. System according to claim 10, wherein the list of actions includes:
- reduce output power for packet data connections;
- reduce total output power for voice calls; and
- change users from high power dissipation modulations to modulations that are more power efficient.

12. System according to claim 11, wherein the list of actions further includes at least one of the following:
- redo frequency allocation;
- reduce total output power; and
- reallocate 2G users from filled up timeslots to empty timeslots.

13. System according to any of claims 10-12, wherein the controller unit (1) is included in any of the following entities:
- a BSC corresponding to the base station (2);
- an RNC corresponding to the base station (2);
- the base station (2).

14. Power amplifier apparatus for optimising operating temperature in a power amplifier (3) of a base station (2) of a cellular telecommunications network, the apparatus including
a temperature sensor for measuring the operating temperature of the power amplifier (3);
an alarm unit for sending an alarm message to a controller unit (1) if the operating temperature exceeds a predetermined temperature threshold T_{TH}; and
a power controller for executing at least one action from a list of actions to reduce the dissipated power of the power amplifier (3) in accordance with instructions from the controller unit (1).

15. A controller unit (1) for optimising operating temperature in a power amplifier (3) of a base station (2) of a cellular telecommunications network, the controller unit (1) including
a receiver for receiving alarm messages from the power amplifier (3), said messages being sent when the operating temperature measured at the power amplifier (3) exceeds a predetermined temperature threshold T_{TH};
a processor for analysing the alarm messages received and, when predetermined conditions are met, executing at least one action from a list of actions to reduce the dissipated power of the power amplifier (3).
